Europäisches Patentamt

European Patent Office

Office européen des brevets

(19)

(11) EP 1 030 453 A1

(12) EUROPEAN PATENT APPLICATION

(43) Date of publication:
23.08.2000 Bulletin 2000/34

(51) Int Cl.⁷: H03L 7/197

(21) Application number: 99100953.1

(22) Date of filing: 20.01.1999

(84) Designated Contracting States:
AT BE CH CY DE DK ES FI FR GB GR IE IT LI LU
MC NL PT SE
Designated Extension States:
AL LT LV MK RO SI

(71) Applicant: Sony International (Europe) GmbH
10785 Berlin (DE)

(72) Inventor: Grässle, Jürgen
72070 Tübingen-5 (DE)

(74) Representative:
MÜLLER & HOFFMANN Patentanwälte
Innere Wiener Strasse 17
81667 München (DE)

(54) A method for reducing transition time in a PLL frequency synthesizer having a programmable frequency divider

(57) For reducing the transition time which is required to switch a PLL circuit comprising a programmable frequency divider (5) from one frequency to another at least one or a certain sequence of additional intermediate divider steps are selected such that the final frequency is approached faster. Appropriate additional intermediate divider steps and their respective time duration are selected from a look-up table or defined according to an algorithm depending on the respectively required frequency change and in consideration of the response of the PLL upon divider switching. No additional or modified hardware is required. The invention is applicable for all kinds of systems comprising programmable PLL circuits.

Fig. 1

**Description**

The invention relates to a method for reducing the transition time required to switch from one frequency to another in a phase locked loop (PLL) frequency synthesizer which comprises a reference frequency source supplying a phase comparator means at a first input thereof with a reference frequency, a programmable frequency dividing means dividing an actual output frequency of a voltage controlled oscillator according to an actual set value of a dividing factor, the output of said frequency dividing means being supplied to a second input of said phase comparator means, the output of which is supplied via a loop filter means as a control voltage to said voltage controlled oscillator.

Phase locked loop frequency synthesizers, in the following PLL circuits, often have a programmable frequency divider to set the output frequency to a defined value. To switch from one frequency to another, the dividing factor of said divider is changed from one value to another. The new frequency can only be reached after some transition time, due to the inherent low-pass characteristic of the PLL circuit.

For achieving a faster frequency settling or lock-up time of PLL circuits, it is known to provide additional hardware measures, i.e. additional control and switching circuitry including a second charge pump for increased cyclical charging/discharging and discharching/charging, respectively, of a low-pass filter contained in the loop filter during a controlling period and according to a time sequence being determined via a charge pump control circuit, either by the frequency difference between a momentaneously selected frequency dividing ratio and a subsequent frequency dividing ratio, or being determined via a microcomputer dependent on a lock-up time which is calculated from a time constant of the low-pass filter and a requested changing amount of the frequency dividing ratios (see Lit. [1]).

For reducing the frequency acquisition time of a PLL circuit, it is also known to implement a frequency detector speed-up circuit comprising a frequency detector and a charge controller for fixing the input to the charge pump from the changing of the division ratio to a defined frequency agreement. A further improvement is achieved by a controlled switching method for changing the time constant of the low-pass filter only during the transition condition (see Lit. [2]).

Both of this known technologies for a faster frequency settling of PLL circuits obviously require a more complex hardware with higher power consumption and/or are prone to loop stability problems because the loop gain is changed, e.g. increased. In other words, for prior art PLL circuits having an improved, i.e. shorter transition time, a more complex hardware is required and/or loop stability problems occur if the loop gain is increased.

It is an object of the invention to enable a speed-up of frequency switching for PLL circuits comprising a programmable frequency divider without changing the PLL loop filter and without requiring any additional hardware measures.

A method for reducing the transition time required to switch from one frequency to another in a PLL frequency synthesizer comprising a programmable frequency divider in accordance with the preamble of claim 1 is characterized in that when changing the output frequency of the PLL frequency synthesizer from an actual frequency to a new output frequency, **before** setting the dividing factor for said programmable frequency dividing means to a new set value corresponding to said new output frequency, the dividing factor is switched for a predetermined time duration to an intermediate value above or below said new set value, respectively, the deviation amount of said intermediate value from said new set value and said time duration being selected in consideration of the loop response of the PLL frequency synthesizer.

According to a preferred embodiment of the method according to the invention, before setting the dividing factor to said new set value, the dividing factor for said programmable frequency dividing means is switched multiple times and in sequential steps to intermediate values above or below and below or above said new set value, respectively, the stepwise declining deviation amount of each intermediate value from said new set value and the duration of each step being determined in adaptation to the response of the PLL frequency synthesizer upon divider switching.

According to this proposal of the invention, the programmable frequency divider of the PLL circuit is preferably switched multiple times in a certain sequence to change the ouput frequency from one value to another. The number of intermediate steps can be any reasonable number to match specific requirements. However, for most purposes, more than two additional steps do not lead to any significant further improvement. On the other hand two steps will usually always outperform one intermediate step only.

The invention and advantageous details thereof will be explained by way of example in the following with reference to the accompanying drawings in which

**Fig. 1** shows the general structure of a PLL circuit comprising a programmable divider;

**Fig. 2A** a state of the art divider switching and a corresponding frequency response;

**Fig. 2B** shows the divider switching according to the method of the invention and a resulting frequency response;

**Fig. 3A and 3B** are diagrams for explaining the principle of the divider timing for one and two intermediate steps, respectively;

**Fig. 4** serves to explain an interpolation scheme for selecting pairs of divider step sizes and time durations to achieve certain reduced values of transition times;

**Fig. 5** is a flow chart for the calculation of interpolated values of step sizes and step duration time;

**Fig. 6** gives an example for the working characteristics of a phase detector;

**Fig. 7** is a typical example for a loop filter;

**Fig. 8** is the graphical presentation of a frequency settling time of a programmable PLL circuit when switched from a first to a second frequency; and

**Fig. 9** is the graphical presentation of the frequency settling time of a PLL circuit for a larger change of the output frequency.

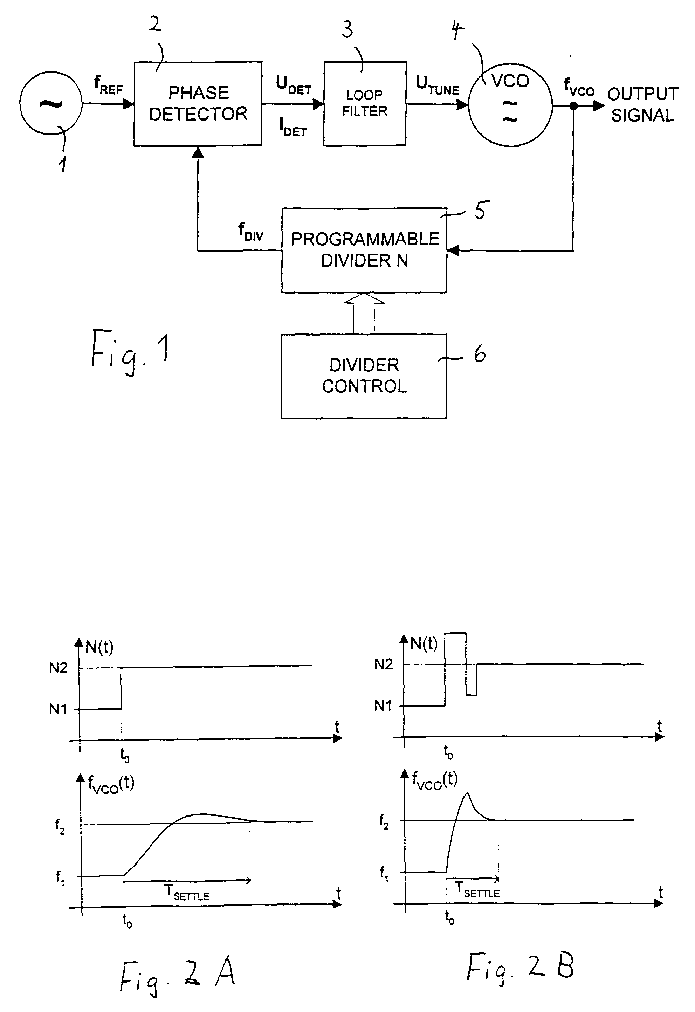

The present invention is applicable to all PLL circuits having the general structure shown in Fig. 1. This PLL circuit comprises an input signal source 1 supplying a frequency $f_{REF}$ and delivering an output signal with a frequency $f_{VCO}$. A programmable divider 5 of which the dividing factor N is determined by a divider control 6 is used to change $f_{VCO}$. If the programmable divider 5 is set to N, the stationary value of $f_{VCO}$ equals $N*f_{REF}$. A phase detector 2 delivers an output signal which is a function of the phase difference of $f_{REF}$ and $f_{DIV}$ supplied by the programmable divider 5. This output signal can be a voltage $U_{DET}$ or a current $I_{DET}$. A loop filter 3 usually having a low-pass filter characteristic is normally used to suppress spurious signals and to improve the phase noise of the output signal $U_{TUNE}$, which is the control signal for a voltage controlled oscillator (VCO) 4 that supplies the frequency $f_{VCO}$.

It should be mentioned that even if the various blocks, i.e. the phase detector 2, the loop filter 3 and the VCO 4 have non-linear characteristics, the invention is likewise applicable.

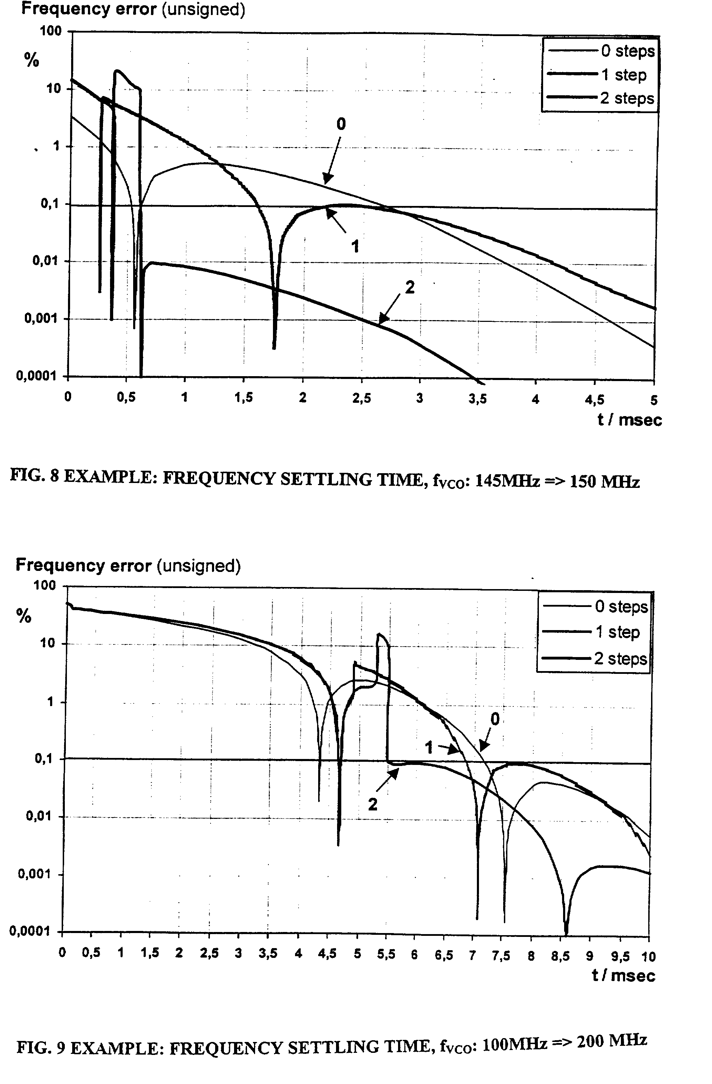

As is generally known, the dynamic behaviour of a PLL circuit is determined by the loop gain and the available current to charge or discharge the capacitor(s) of the loop filter for which a typical example is shown in Fig. 7. For achieving a fast frequency switching, the loop gain and/or the available current for charging/discharging the capacitor (s) have to be increased. However, as already mentioned, the loop gain can only be increased as long as stability, phase noise and spurious signals are not unacceptable degraded. On the other hand, charging and discharging currents are limited by the used components, e.g. in particular for the phase detector IC or are limited under power consumption requirements.

With the divider switching sequence according to the method of the invention, it becomes possible to reduce the frequency settling times of PLL circuits of the type shown in Fig. 1 without modifying the hardware structure of the PLL circuit itself.

The principle behaviour of the PLL circuit upon divider switching and the corresponding frequency response is shown in Fig. 2A for the state of the art switching, and in Fig. 2B for a switching scheme according to the invention. A state of the art switching is done by changing the divider ratio N in the programmable divider 5 at a time instant $t_0$ from an initial value $N_1$ to a new value $N_2$. The settling time or transition time is defined as the time period $T_{SETTLE}$ which has to pass until the frequency $f_{VCO}$ stays continuously within a specified tolerance near the final new value $f_2$.

According to the invention, preferably the programmable frequency divider 5 is switched multiple times in a certain sequence to change the ouput frequency from one value $f_1$ to another value $f_2$. Even though the number of intermediate steps can be any reasonable value to match specific requirements, for the application considered here by way of example more than two additional steps did not provide for further significant improvements. However, as will be seen from the following, two steps can always outperform one intermediate step only.

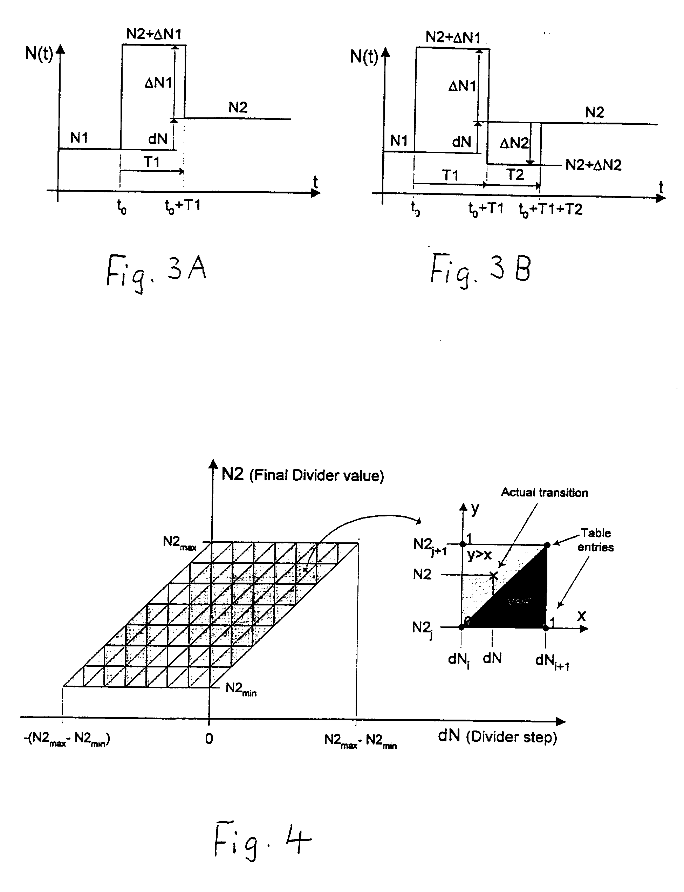

Fig. 3A shows the principle divider timing and divider steps for one intermediate step, whereas Fig. 3B serves to explain the principle according to the invention for two intermediate steps. An extension to three or more steps is a straightforward possibility by adding pairs of divider steps $\Delta N\nu$ and time instants or time duration $T\nu$. Suitable values of the intermediate divider steps $\Delta N\nu$ ($\nu = 1,2, ...$) and time durations $T\nu$ depend on a specific given PLL circuit configuration and the frequency step to be performed.

Some general ways for finding suitable intermediate divider steps according to the invention will be given in the following.

To reduce the settling time, a certain product of $\Delta N\nu * T\nu$ is required. Accordingly, a trade-off between $\Delta N\nu$ and $T\nu$ is possible which allows in most cases one of the two parameters to be fixed. But the achievable reduction in settling time depends to some extent on the respectively fixed parameter. As a rule, higher divider steps $\Delta N\nu$ and

correspondingly shorter time durations Tν give shorter settling times. To find suitable intermediate steps, a circuit simulator or a measurement set-up or both can be used. Known simulation tools allow to calculate the settling time of a PLL circuit including the switched frequency divider. Such tools can be used to select the best combinations of ΔNν and Tν especially for an automatic optimisation. For example, if the settling time can be measured, an iterative modification of the values for ΔNν and Tν can be made until a suitable pair or set is found.

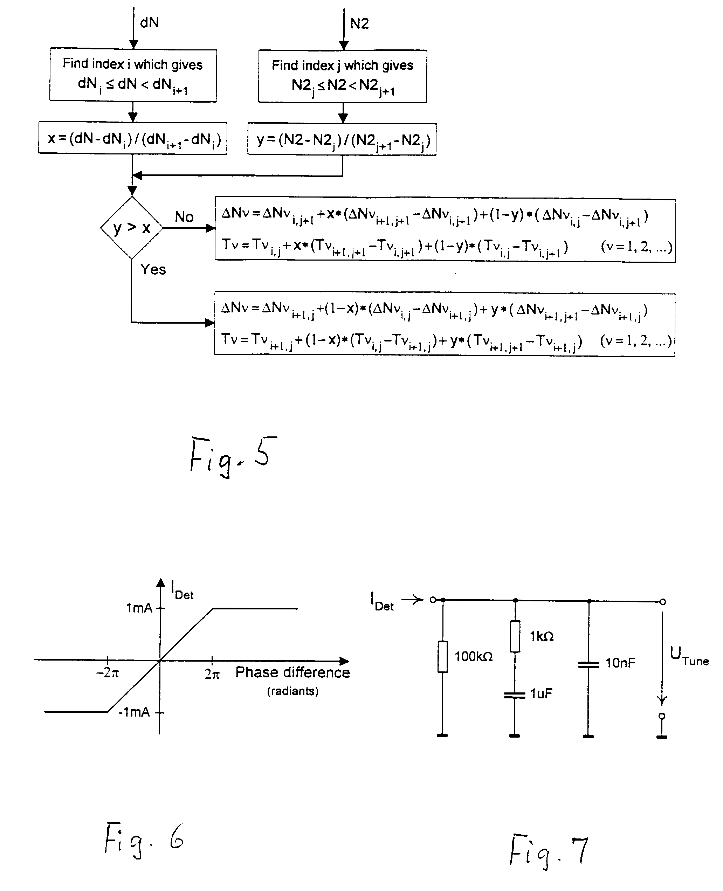

If the considered PLL circuit requires only transitions between few frequencies, a look-up table containing appropriate candidates for ΔNν and Tν for each possible transition can be used. Such a look-up table can be organized in rows of $dN_i$ and columns of $N2_j$, where i is the index of the divider stepsize and j is the index of the final divider value. Each table entry contains the ΔNν and Tν for that specific combination, where v is the index of the intermediate steps as defined in Fig. 3A and in Fig. 3B. Otherwise new sets of Tν and ΔNν can be calculated by interpolation between a reasonable number of table entries or by extrapolating around known sets. If for example $N2_{min}$ and $N2_{max}$ are the minimal and maximal values for a final divider value N2, all possible transitions are within the shaded area of the left-hand diagram of Fig. 4. Such table entries may be located in an equidistant or non-equidistant grid of co-ordinates $(dN_i, N2_j)$ as described above. Interpolation for a certain transition time given by a pair (dN, N2) can be performed by interpolating between three neighbouring table entries. The right-hand side diagram in Fig. 4 shows the association of an actual point "x" to the respective three table entries, which are located at the comers of the triangle as indicated by arrows.

A flowchart for the calculation of interpolation values for ΔNν and Tν is given in Fig. 5. The caluculated ΔNν has to be rounded to the next integer value.

If a set of $\Delta N\nu_n$ and $T\nu_n$ is known for the divider step from $N1_n$ to $N2_n$, the parameters for a step from $N1_m$ to $N2_m$ can be extrapolated as:

$$T\nu_m = T\nu_n \tag{1}$$

n = index of known transition parameters
m = index of unknown transition parameters

$$\Delta N\nu_m = \frac{dNm}{dN_n} * \frac{1}{\frac{1}{\Delta N\upsilon_n} + \frac{1}{N2_n} - \frac{1}{N2_m}} \tag{2}$$

ν = 1,2 ... designator of intermediate step

The first term of the above equation (2) for $dN\nu_m$ accounts for changes between the divider steps $dN_m = N2_m - N1_m$ and $dN_n = N2_n - N1_n$. The second term makes an adaptation if the final divider ratio $N2_m$ is different from $N2_n$. The formula fits best if the PLL circuit has no strong non-linear or saturating characteristics and if $dN_m \cong dN_n$ and $N2_m \cong N2_n$.

An example for a typical PLL circuit is given below with reference to Figs. 6 to 9. This example shall not be interpreted as limitation to a certain PLL circuit structure but as an illustration of the invention only. This example represents a simulation for a PLL circuit having the circuit structure of Fig. 1 and the following characteristics:

$f_{REF}$ = 25 kHz
The current output of the phase detector 2 has the characteristic shown in Fig. 6.
For the loop filter 3 a circuit arrangement as shown in Fig. 7 is assumed.
For the VCO 4: $f_{VCO}$ = 80 MHz + 20 MHz*$U_{TUNE}$/V.
For the VCO 4: $f_{VCO}$ = 80 MHz + 20 MHz*$U_{TUNE}$/V.

For this PLL circuit, the settling time to a residual error of $\alpha$ = 0.1 % was optimised.

The resulting set or pair of ΔNν and Tν for a transition from 145 MHz to 150 MHz (N1 = 5800, N2 = 6000) are shown in Table 1 below. ΔN1 was set to 800; higher values of ΔN1 give slightly better results; lower perform somewhat worse.

Table 1:

| ΔNν and Tν for optimised switching from 145 MHz to 150 MHz | | | | | | |
|---|---|---|---|---|---|---|
| Intermediate steps | $T_{settle}$/msec α ≤ 0.1% | | ΔN1 | T1/msec | ΔN2 | T2/msec |
| 0 | 2.64 | (100%) | | | | |
| 1 | 1.59 | (-39.7%) | 800 | 0.262 | | |
| 2 | 0,604 | (-77.1 %) | 800 | 0.368 | -500 | 0.225 |

The frequency error for this transition is shown in Fig. 8. If only one additional step is used, the target error (e.g. α = 0.1 %) is achieved faster, but the settling to lower errors is not improved. Two intermediate steps lead to a significant improvement for residual errors below the said target error. The penalty is a higher, however, still acceptable overshoot due to the switching of the programmable divider 5.

In Table 2 below the sets of ΔNν and Tν for a transition from 100 MHz to 200 MHz (N1 = 4000, N2 = 8000) are given. ΔN1 was set to 250. Fig. 9 shows the frequency error for that case. In contrast to the transition from 145 MHz to 150 MHz, the phase detector 2 is operated in a current limiting range due to the wide frequency step. In this current limited operation, the achievable reduction in settling time is lower, but some improvement is possible as visualized by Fig. 9.

Table 2:

| ΔNν and Tν for optimised switching from 100 MHz to 200 MHz | | | | | | |
|---|---|---|---|---|---|---|
| Intermediate steps | $T_{settle}$/msec α ≤ 0.1 % | | ΔN1 | T1/msec | ΔN2 | T2/msec |
| 0 | 7.17 | (100 %) | | | | |
| 1 | 6.87 | (-4.2 %) | 250 | 4.9 | | |
| 2 | 5,47 | (-23.7 %) | 250 | 5.286 | -700 | 0.2 |

As becomes evident from the above description, the invention can be applied to all PLL circuits which have a programmable divider. The improvements according to the invention can be added to any existing circuit of this type by a modification of the software only. It is a significant advantage of the invention that this software-based speed-up-scheme requires no additional or modified hardware.

Specific fields of application of the invention are all kinds of systems where programmable PLL circuits are used. Examples are receivers for audio, TV, telecommunication and measurement instruments.

**Literature List**

Lit. [1]:     EP 0 595 787 A2

Lit. [2]:     FAST SETTLING PLL FREQUENCY SYNTHESIZER UTILIZING THE FREQUENCY DETECTOR METHOD SPEEDUP CIRCUIT - IEEE Transactions on Consumer Electronics, Vol. 43, No. 3, AUGUST 1997

**Claims**

1.  A method for reducing the transition time required to switch from one frequency to another in a PLL frequency synthesizer comprising:

    -   a reference frequency source (1) supplying a phase comparator means (2) at a first input thereof with a reference frequency ($f_{REF}$);
    -   a programmable frequency dividing means (5) dividing an actual output frequency ($f_{VCO1}$) of a voltage controlled oscillator (4) according to an actual set value (N1) of a dividing factor (N), the output of said frequency dividing means (5) being supplied to the second input of said phase comparator means (2), the output of which is supplied via a loop filter means (3) as a control voltage ($U_{TUNE}$) to said voltage controlled oscillator (4)

**characterized in that**

- when changing the output frequency of said voltage controlled oscillator (4) from said actual frequency ($f_{VCO1}$) to a new ouput frequency ($f_{VCO2}$), before setting the dividing factor (N) for said programmable frequency dividing means (5) to a new set value (N2) corresponding to said new output frequency ($f_{VCO2}$), the dividing factor (N) is switched for a predetermined time duration (Tν) to an intermediate value (N2 ± ΔNν) above or below said new set value (N2), respectively, the deviation amount (ΔNν) of said intermediate value from said new set value (N2) and said time duration (Tν) being selected in consideration of the response of the PLL frequency synthesizer upon divider switching.

2. The method of claim 1 **characterized in that** before setting the dividing factor to said new set value (N2), the dividing factor (N) for said programmable frequency divider means (5) is switched multiple times and in sequential steps to intermediate values above or below and below or above said new set value (N2), respectively, the stepwise declining deviation amount (ΔNν; ν = 1, 2, ...) of each intermediate value (N2 ± ΔNν) from said new set value (N2) and the duration of each step (Tν) being determined in adaptation to the response of the PLL frequency synthesizer upon divider switching.

3. The method of claim 1 or 2 **characterized in that** for a defined output frequency range of said PLL frequency synthesizer appropriate pairs of deviation amount (ΔNν) and step duration (Tν) are calculated on the basis of an algorithm in consideration of the response of the PLL frequency synthesizer upon divider switching for a plurality of possible transitions.

4. A PLL frequency synthesizer arrangement comprising:

- a reference frequency source (1) supplying a phase comparator (2) at a first input thereof with a reference frequency ($f_{REF}$),
- a programmable frequency divider (5) dividing an actual output frequency ($f_{VCO1}$) of a voltage controlled oscillator (4) according to an actual set value of a dividing factor (N1) supplied by a divider control (6) to said frequency divider (5), the output of said frequency divider (5) being supplied to a second input of said phase comparator (2), the output of which is supplied via a loop filter (3) as a control voltage to said voltage controlled oscillator (4) **characterized in that** means are provided in said divider control (6) for reducing the transition time required when switching said programmable divider from one setting of a first dividing factor (N1) corresponding to a first output signal frequency ($f_{VCO1}$) to another setting (N2) corresponding to another output signal frequency ($f_{VCO2}$) and including means for switching the dividing factor (N) before setting said second dividing factor (N2) for a predetermined time duration (Tν) to an intermediate value (N2 ± ΔNν) above or below said second dividing factor (N2), respectively, the deviation amount (ΔNν) of said intermediate value from said new second dividing factor (N2) and said time duration (Tν) being selected in consideration of the response of said loop filter (3).

5. A PLL frequency synthesizer arrangement according to claim 4, **characterized in that** said switching means are adapted for switching the dividing factor, before setting said second dividing factor (N2), for a plurality of consecutive time intervals (Tν) to intermediate step-wise declining values (N2 ± ΔNν) above or below and below or above said new dividing factor (N2), respectively, the deviation amount (ΔNν; ν = 1, 2, ...) of each intermediate value from said second dividing factor (N2) and said consecutive time intervals (Tν) being selected in consideration of the response of said loop filter (3).

Fig. 1

Fig. 2 A

Fig. 2 B

Fig. 3A

Fig. 3B

Fig. 4

Fig. 5

Find index i which gives
$dN_i \leq dN < dN_{i+1}$

Find index j which gives
$N2_j \leq N2 < N2_{j+1}$

$x = (dN - dN_i) / (dN_{i+1} - dN_i)$

$y = (N2 - N2_j) / (N2_{j+1} - N2_j)$

$y > x$

No

Yes

$$\Delta N\nu = \Delta N\nu_{i,j+1} + x*(\Delta N\nu_{i+1,j+1} - \Delta N\nu_{i,j+1}) + (1-y)*(\Delta N\nu_{i,j} - \Delta N\nu_{i,j+1})$$
$$T\nu = T\nu_{i,j} + x*(T\nu_{i+1,j+1} - T\nu_{i,j+1}) + (1-y)*(T\nu_{i,j} - T\nu_{i,j+1}) \qquad (\nu = 1, 2, ...)$$

$$\Delta N\nu = \Delta N\nu_{i+1,j} + (1-x)*(\Delta N\nu_{i,j} - \Delta N\nu_{i+1,j}) + y*(\Delta N\nu_{i+1,j+1} - \Delta N\nu_{i+1,j})$$
$$T\nu = T\nu_{i+1,j} + (1-x)*(T\nu_{i,j} - T\nu_{i+1,j}) + y*(T\nu_{i+1,j+1} - T\nu_{i+1,j}) \qquad (\nu = 1, 2, ...)$$

Fig. 6

Fig. 7

**Frequency error (unsigned)**

FIG. 8 EXAMPLE: FREQUENCY SETTLING TIME, $f_{VCO}$: 145MHz => 150 MHz

**Frequency error (unsigned)**

FIG. 9 EXAMPLE: FREQUENCY SETTLING TIME, $f_{VCO}$: 100MHz => 200 MHz

EP 1 030 453 A1

**European Patent
Office**

**EUROPEAN SEARCH REPORT**

Application Number

EP 99 10 0953

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 682 413 A (NIPPON ELECTRIC CO) 15 November 1995 * column 3, line 55 – column 9, line 43 * --- | 1-5 | H03L7/197 |
| X | US 5 371 480 A (HEDBERG BO ET AL) 6 December 1994 * column 3, line 30 – column 5, line 50 * --- | 1-5 | |
| X | EP 0 461 358 A (MITSUBISHI ELECTRIC CORP) 18 December 1991 * page 5, line 12 – page 7, column 19 * --- | 1-5 | |
| A | US 5 420 545 A (DAVIS CRAIG M ET AL) 30 May 1995 * the whole document * --- | | |
| A | EP 0 727 877 A (MATSUSHITA ELECTRIC IND CO LTD) 21 August 1996 * the whole document * ----- | | |

TECHNICAL FIELDS
SEARCHED (Int.Cl.6)

H03L

The present search report has been drawn up for all claims

| Place of search | Date of completion of the search | Examiner |
|---|---|---|
| MUNICH | 16 June 1999 | Kahn, K-D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

11

**ANNEX TO THE EUROPEAN SEARCH REPORT
ON EUROPEAN PATENT APPLICATION NO.**

EP 99 10 0953

This annex lists the patent family members relating to the patent documents cited in the above-mentioned European search report.
The members are as contained in the European Patent Office EDP file on
The European Patent Office is in no way liable for these particulars which are merely given for the purpose of information.

16-06-1999

| Patent document cited in search report | | Publication date | Patent family member(s) | | Publication date |
|---|---|---|---|---|---|
| EP 0682413 | A | 15-11-1995 | JP | 2616582 B | 04-06-1997 |
| | | | JP | 7303042 A | 14-11-1995 |
| | | | AU | 693863 B | 09-07-1998 |
| | | | AU | 1791295 A | 16-11-1995 |
| | | | CA | 2148896 A | 10-11-1995 |
| | | | CN | 1117672 A | 28-02-1996 |
| | | | DE | 69501752 D | 16-04-1998 |
| | | | DE | 69501752 T | 02-07-1998 |
| | | | US | 5661440 A | 26-08-1997 |
| US 5371480 | A | 06-12-1994 | AU | 669417 B | 06-06-1996 |
| | | | AU | 5662494 A | 04-07-1994 |
| | | | CA | 2129450 A | 05-06-1994 |
| | | | CN | 1090443 A | 03-08-1994 |
| | | | DE | 69324477 D | 20-05-1999 |
| | | | EP | 0625292 A | 23-11-1994 |
| | | | JP | 7506235 T | 06-07-1995 |
| | | | WO | 9414243 A | 23-06-1994 |
| EP 0461358 | A | 18-12-1991 | JP | 2798142 B | 17-09-1998 |
| | | | JP | 4047812 A | 18-02-1992 |
| | | | DE | 69129680 D | 06-08-1998 |
| | | | DE | 69129680 T | 22-10-1998 |
| | | | NO | 177948 B | 11-09-1995 |
| | | | US | 5107220 A | 21-04-1992 |
| US 5420545 | A | 30-05-1995 | NONE | | |
| EP 0727877 | A | 21-08-1996 | JP | 8223037 A | 30-08-1996 |
| | | | US | 5694089 A | 02-12-1997 |

EPO FORM P0459

For more details about this annex : see Official Journal of the European Patent Office, No. 12/82